# EUROPEAN PATENT SPECIFICATION

(11) **EP 2 929 629 B1**
(45) Date of publication and mention of the grant of the patent: **07.06.2023**
(21) Application number: 13815104.8
(22) Date of filing: 06.12.2013
(51) Int. Cl.: H04B 1/18, H01P 1/213, H03H 7/46, H04B 1/52, H01P 5/16

(54) **APPARATUS FOR ALLOWING RADIO FREQUENCY SELECTIVITY AND METHOD OF USE THEREOF**
VORRICHTUNG ZUR ERMÖGLICHUNG EINER FUNKFREQUENZAUSWAHL UND VERFAHREN ZUR VERWENDUNG DAVON
APPAREIL POUR PERMETTRE UNE SÉLECTIVITÉ RADIOFRÉQUENCE ET SON PROCÉDÉ D'UTILISATION

(30) Priority: 07.12.2012 GB 201222019
(43) Date of publication of application: 14.10.2015
(73) Proprietor: Radio Design Limited, West Yorkshire BD17 7DW (GB)
(72) Inventor: PARRY, Richard, Shipley West Yorkshire BD17 7DW (GB); SLEIGH, Philip, Shipley West Yorkshire BD17 7DW (GB); HUNTER, Ian, Shipley West Yorkshire BD17 7DW (GB)
(74) Representative: Tomkinson, Alexandra
(86) International application number: PCT/GB2013/053225
(87) International publication number: WO 2014/087171

(56) References cited:
- EP-A1- 2 355 235
- EP-A2- 0 284 442
- WO-A1-2006/121402
- US-A- 5 155 724
- US-A1- 2007 096 846
- US-A1- 2009 219 908
- US-A1- 2009 231 056
- US-A1- 2010 329 387
- US-A1- 2012 306 590
- US-B1- 6 278 498
- US-B2- 7 941 187

## Description

This invention relates to apparatus for allowing radio frequency selectivity and a method of use thereof, and particularly, although not necessarily exclusively, to filter, multiplexer or combiner apparatus for use in a wireless communication network.

A wireless communication network typically includes a plurality of cell sites which allow radio frequency (RF) signals to be transmitted to and received from mobile phone units. Each cell site typically includes a mast, at the top of which is typically mounted an antenna for transmitting and/or receiving one or more radio frequency signals, and optionally a tower mounted amplifier (TMA) for amplifying the radio frequency signals from the antenna to a base transceiver station (BTS). The BTS is typically located at the base of the mast and is connected to the TMA, if provided, and antenna via two feeder cables. The BTS typically includes a transceiver that generates one or more radio frequency signals for transmission to a mobile phone unit, as well as receiving one or more radio frequency signals from the mobile phone unit.

Conventionally the wireless connections between a cell site and a mobile phone unit have been made using a number of different frequency bands per region. For example, in the UK these frequency bands are at 900MHz, 1800MHz and 2100MHz. Each frequency band has also conventionally been assigned to a particular technology; the 900MHz and 1800MHz bands have historically been licensed for second generation (2G) system use only, and the 2100MHz band has been licensed for third generation (3G) system use. As 3G systems support higher data rates than 2G systems, the licenses for frequency bands previously restricted to 2G systems only have now been amended to allow 3G systems and potentially fourth generation (4G) systems to be deployed within them. In addition, further bandwidth is being made available via freeing up additional frequency bands. Mobile communication operators therefore need to invest significant amounts of money in their networks to provide the latest technologies in multiple bands whilst continuing to support legacy technology/band combinations. Consequently, mobile communication operators are under pressure to reduce capital expenditure (CAPEX) and operating expenditure (OPEX) wherever possible in their wireless communication networks.

A significant opportunity for cost saving for a mobile communication operator is sharing of network infrastructure in that a single operator can share infrastructure between equipment operating in different bands or operating in the same band and utilising different technologies (e.g. 2G and 3G) and/or the infrastructure can be shared between two different operators.

Conventionally, a BTS at a cell site has been required for each frequency band, each operator and each technology. A common cell site configuration would therefore comprise splitting the area to be covered by the wireless communications network into three 120 degree sectors, with each sector serviced by an antenna configuration that provides a pair of statistically independent reception and/or transmission paths to the mobile phone units. There are several methods for producing such an antenna configuration including spatial diversity and X-polarised antennas. The feeder cables, TMAs and antennae are often referred to as an antenna system. In all cases the antenna systems will have a pair of ports, each port associated with one of the statistically independent paths. Within each sector the cell site may transmit on one or both antenna ports but it will receive on both. The use of two statistically independent paths for receiving a signal is referred to as receive diversity and improves the sensitivity of the BTS receiver. Receiver sensitivity directly impacts the cell site coverage and capacity.

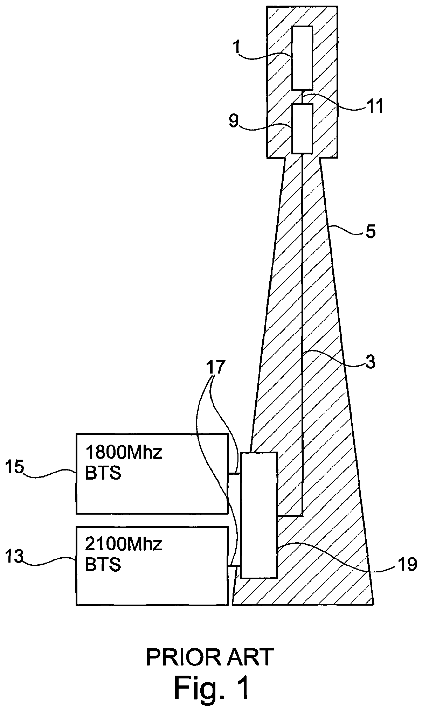

It is known to be able to provide combiner apparatus that facilitates sharing of apparatus at a cell site for two different operators using different radio frequency bands, or a single operator using different radio frequency bands, as shown in figure 1. The combiner apparatus 19 uses any or any combination of one or more band pass and/or bandstop filters tuned to the different radio frequency bands (i.e. 1800MHz and 2100MHz) to provide isolation of the transmission and receiving signals of the different frequency bands. A separate BTS 13, 15 will typically be provided for each different operator or for the different radio frequency bands and the combiner apparatus 19 combines the transmission signals from the respective BTS's 13, 15 onto the common antenna system and, in turn, splits combined received signals from the common antenna system to the respective BTS's. In Figure 1, the antenna is shown as reference numeral 1, the TMA is shown as reference numeral 9, the cable joining the antenna 1 to the TMA is shown as reference numeral 11, the mast is shown as reference numeral 5, the cables joining the BTSs 13, 15 to the combiner apparatus 19 are shown as reference numeral 17, and the cable joining the combiner apparatus 19 to the TMA is shown as reference numeral 3.

The provision of combiner apparatus at a cell site that allows two BTS's that operate in a single frequency band (i.e. two different operators using the same frequency band or a single operator using the same frequency band for different technologies) to share an antenna system is generally more challenging. This is because the guard band between the respective operating radio frequency sub bands of the BTS's can be small. This in turn reduces the isolation between input ports of the combiner apparatus which, in some cases, can lead to transmission signal noise generated by one BTS, falling within the receive band of the other BTS, leaking through the combiner apparatus into the other BTS, thereby desensitising its receiver and reducing its coverage and uplink capacity. A further problem is that even if the combiner apparatus operates successfully, the need for a high degree of isolation between the respective radio frequency sub bands of the single frequency band results in relatively high performance filters being required within the combiners to be provided as part of the system. Such high performance filters are relatively large and are therefore either difficult to physically fit in the available space of the combiner apparatus or require the size of the combiner to be relatively large. High performance filters are also expensive pieces of equipment which can reduce the cost advantage to be gained by sharing infrastructure.

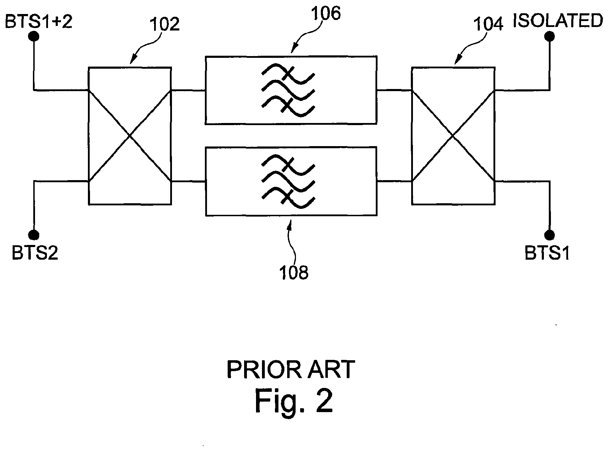

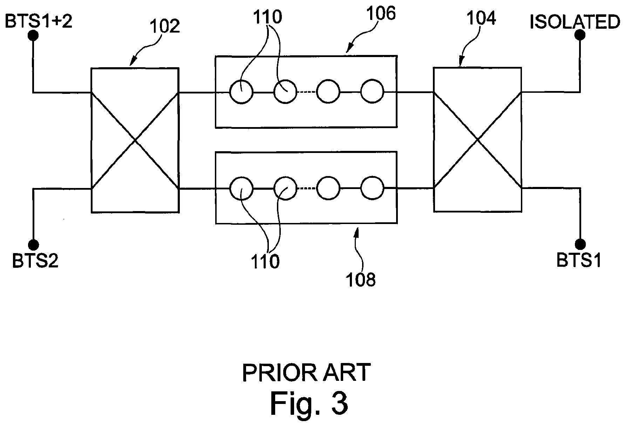

In an attempt to overcome the abovementioned problem it is known to use combiner apparatus, often referred to as a directional filter, that uses two 3dB hybrid couplers 102, 104 with a pair of identical pass band filters 106, 108 arranged in parallel between the couplers, an example of which is shown in figure 2. In this arrangement the hybrid couplers 102, 104 provide the directivity which isolates the sub-bands within the single frequency band of BTS1 and BTS2, thereby allowing filters to be used in the apparatus that are smaller in size and have lower performance characteristics than conventional apparatus. A feature of the filters 106, 108 used in the arrangement shown in figure 2 is that each filter includes a plurality of cascading resonators 110 coupled together, as shown in figure 3, with each radio frequency signal passing through a particular filter passing through each of the coupled resonators 110 in turn. As such, the resonators 110 of each filter are coupled together and typically this requires them to be made from the same resonator technology with substantially the same Q (Quality Factor), and typically a high Q, to provide high resonator performance characteristics. This leads to large and expensive filters within the apparatus.

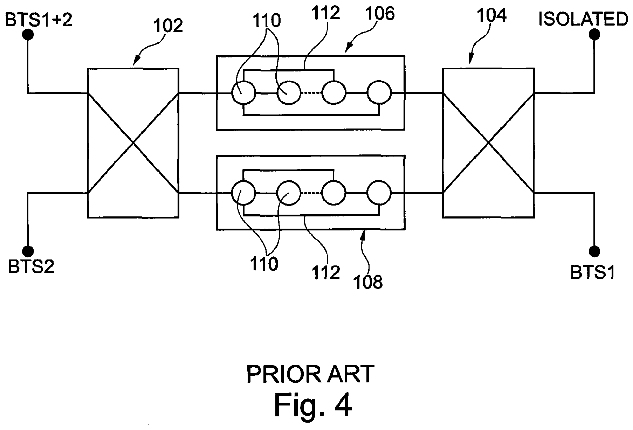

Cross coupling 112 between the filter resonators and/or the filter input and/or output, as shown in figure 4, could be used to provide transmission zeros in the response improving the frequency selectivity of the combiner and reducing the size of the guard band between the two radio frequency sub-bands. However, as the guard band is decreased the resonator's Q has to increase to maintain the band edge insertion loss performance and this leads to large expensive resonators and hence large expensive combiners. In addition, the couplings that are required to produce cross couplings can be extremely difficult to physically realise as the resonators that need to be coupled together are physically remote from one another and therefore it may not be possible to generate all the transmission zeros required for the optimum response.

US2012/306590 discloses a band combining filter comprising a cascade of filter sections and a phase shifter. Each filter section comprises a 3dB hybrid coupled by resonators, where each 3dB hybrid could be considered to generate a 90 degree phase shift.

US2009/231056 discloses a combiner apparatus comprising a plurality of cascaded directional filters, each filter having at least two inputs and at least two outputs. The signal splitters in the directional filters are 3dB hybrids.

WO2006/121402 discloses a filter combiner apparatus comprising a first directional coupler connected to at least one first filter, to an antenna branch, to at least a second filter and to a first signal branch. The combiner also comprises a second directional coupler connected to that at least one filter, to a second signal branch and to at least one second filter. The directional couplers are defined as being hybrids or Magic T's. US2009/219908 discloses a system for processing radio frequency signals via diplexers embedded in an integrated circuit package. The diplexer may include hybrid couplers which include quarter wavelength transmission lines. The diplexer can be coupled to one or more capacitors.

It is therefore an aim of the present invention to provide alternative apparatus for allowing radio frequency selectivity that has improved performance with reduced costs and size associated with the same.

It is a further aim of the present invention to provide a method of using apparatus for allowing radio frequency selectivity that has improved performance with reduced costs and size associated with the same.

It is a yet further aim of the present invention to provide combiner apparatus.

It is a yet further aim of the present invention to provide a method of using combiner apparatus.

According to a first aspect of the present invention there is provided apparatus for allowing radio frequency selectivity for use in a wireless communication system for the passage of one or more receiving and/or transmission frequency signals therethrough according to claim 1.

The arrangement of the present invention allow transmission zeros to be created in the transfer function of the apparatus without the requirement for cross coupling between the resonating means or resonators as there is in the prior art. In addition, it allows resonating means or resonators made from different technologies, having a different Q and/or the like to be used in the same apparatus without the problems associated with the prior art.

In one embodiment the apparatus is in the form of combiner apparatus.

In an alternative embodiment the apparatus is in the form of multiplexer apparatus.

In a further alternative embodiment the apparatus is in the form of filter apparatus. The filter apparatus could be any or any combination of a bandpass, bandstop, lowpass, highpass filter apparatus and/or the like.

The cascading between the different sets of first and second 90 degree phase shift coupling means is arranged such that one or more radio frequency signals can pass between the different sets of first and second 90 degree phase shift coupling means. For example, in one embodiment the cascading is undertaken using one or more transmission lines. The at least one pair of resonating means could include a single resonator with at least two resonator modes or sections provided in or associated with the same coupled together. Alternatively, or in addition, the at least one pair of resonating means could include at least two separate (i.e. physically independent and distinct) resonators coupled together.

Preferably the resonating means include any or any combination of one or more ceramic rods, combline resonators, ceramic pucks and/or the like.

In one embodiment the resonating means used in the apparatus are substantially the same (i.e. provided with substantially the same or similar Q value, formed from the same material and/or the like).

In one embodiment two or more of the resonating means used in the apparatus are different (i.e. provided with different Q values, formed from different materials and/or the like). Thus, in one embodiment the resonating means can be arranged such that narrow band resonating means or resonators are provided which contribute most to the band edge insertion loss and are typically made from high Q technologies, whilst wider band resonating means or resonators are also provided which are typically made from low Q technologies. This in turn reduces the cost of the apparatus. In this embodiment there is no necessity for interaction between the different resonator technologies.

In one unclaimed embodiment the apparatus includes at least a first set of first and second 90 degree phase shift coupling means with at least one pair of resonating means provided between the same, and at least one further set of first and second degree phase shift coupling means with no resonating means provided therebetween.

For example, in the embodiment where there are n sets of first and second 90 degree phase shift coupling means with one pair of resonating means provided between the 90 degree phase shift coupling means of each set, a response with n-1 transmission zeros can be obtained. In the embodiment where there are n sets of first and second 90 degree phase shift coupling means with one pair of resonating means provided between the 90 degree phase shift coupling means of each set, and one set of first and second 90 degree phase shift coupling means with no resonating means provided between them, a response of n transmission zeros can be obtained. These embodiments allow a greater number of transmission zeros of the apparatus response to be realised with a practical design compared to the prior art.

In one unclaimed embodiment the apparatus includes the first set of first and second 90 degree phase shift coupling means with at least one pair of resonating means provided between the same, and at least one further set of first and second 90 degree phase shift coupling means with at least one pair of resonating means therebetween.

In one embodiment each of the paths separating two or more sets of 90 degree phase shift coupling means in the apparatus will have a phase shift and the difference between the shifts will be substantially 180 degrees. However, the phase difference could be any required value or could be zero.

Thus, in this unclaimed embodiment a plurality of sets of 90 degree phase shift coupling means with associated resonating means can be provided that are cascaded together to provide a desired transfer function. Any number of phase shifts can be provided as required. The phase shifts can be provided in any of the paths between the 90 degree phase shift coupling means, providing they result in the required phase difference in the paths.

The 90 degree phase shift coupling means is in the form of a transmission line with an electrical length of 90 degrees (also referred to as a quarter wavelength transmission line). The transmission line is coupled to the at least one pair of resonating means with one end of the transmission line coupled to one of the resonating means and the other end of the transmission line coupled to the resonating means and a coupling is provided between the at least one pair of resonating means. In the above embodiment preferably the first and at least second set of 90 degree phase shift coupling means are cascaded by connecting or coupling, either directly or indirectly, the end of the transmission line within the first 90 degree phase shift coupling means of the first set of 90 degree phase shift coupling means with the start of the transmission line of the first 90 degree phase shift coupling means of the second set and the end of the transmission line within the second 90 degree phase shift coupling means of the first set of 90 degree phase shift coupling means with the start of the transmission line of the second 90 degree phase shift coupling means of the second set. Subsequent sets are cascaded in a similar manner.

In the abovementioned embodiment, the physical couplings between the transmission lines and the resonator means of a set or between sets can be of the same coupling type (i.e. all magnetic (+ve) couplings or all electrical (-ve) couplings). Alternatively, the physical couplings between the transmission lines and resonator means of one or more sets or between one or more sets can be of a different coupling type (i.e. some magnetic (+ve) couplings and some electrical (-ve) couplings), such that it may not be necessary to have a phase difference of 180 or 'x' degrees between two sets of 90 degree phase shift coupling means and/or resonators (wherein `x'= a required phase shift value).

In one embodiment the physical couplings between the transmission lines and the resonator means and/or between the 90 degree phase shift coupling means and the resonator means can be symmetrical in that they have the same coupling value.

In one embodiment the physical couplings between the transmission lines and the resonator means and/or between the 90 degree phase shift coupling means and the resonator means can be non-symmetrical or different. This allows the poles and zeros of the transfer function of apparatus with finite Q resonators to be recovered.

In one embodiment the apparatus is combiner apparatus and the combiner apparatus communicates with at least first and second base transceiver stations (BTSs). Preferably the receiving means of the first base transceiver station is arranged to receive one or more receiving signals of a first radio frequency sub-band within a known frequency band and the second base transceiver station is arranged to receive one or more receiving signals of a second radio frequency sub-band within said known frequency band. The first radio frequency receive sub-band is typically different to or distinct from the second radio frequency receive sub-band.

Preferably the transmission means of the first base transceiver station is arranged to transmit one or more transmission signals to an antenna of a first radio frequency sub-band within a known frequency band and the second base transceiver station is arranged to transmit one or more transmission signals to an antenna of a second radio frequency sub-band within said known frequency band. The first radio frequency transmit sub-band is typically different to or distinct from the second radio frequency transmit sub-band.

Preferably, the transfer function of the apparatus will define one or more passbands and signals whose frequency falls within one of the passbands will be attenuated by a relatively small amount compared to signals whose frequencies lie outside the one or more passbands.

Preferably the resonator means of different sets of 90 degree phase shift coupling means are tuned to different RF frequencies.

In one embodiment the resonator means include one or more bandpass resonators.

In one embodiment the resonator means include one or more bandstop resonators.

In one embodiment the combiner apparatus is a dual combiner apparatus including two electronic circuits provided therein. Preferably the two electronic circuits are mirror images of each other.

According to a further aspect of the present invention there is provided a method of using apparatus for allowing radio frequency selectivity for use in a wireless communication system for the passage of one or more receiving and/or transmission frequency signals therethrough according to claim 15.

Embodiments of the present invention will now be described with reference to the accompanying figures, wherein:
Figure 1 is a simplified view of PRIOR ART combiner apparatus that can be used on a cell site for allowing two different operators using different radio frequency bands or a single operator using different radio frequency bands to use a common antenna and mast;
Figure 2 is a simplified view of PRIOR ART combiner apparatus using two 3dB hybrid couplers with a pair of identical bandpass filters arranged in parallel therebetween;
Figure 3 is a simplified view of the PRIOR ART combiner apparatus in figure 2 showing that each filter includes a plurality of resonators coupled together;
Figure 4 is a simplified view of PRIOR ART combiner apparatus using two 3dB hybrid couplers with a pair of filters arranged in parallel therebetween with cross couplings provided between the resonators of each filter;
Figure 5 is a simplified view of a cell site of a type to which the combiner apparatus of the present invention relates;
Figure 6a is a simplified view of combiner apparatus according to one possible arrangement not covered by the present invention with a 180 degree phase shift in one of the paths between two sets of 90 degree phase shift coupling means and resonator means;
Figure 6b is a simplified view of combiner apparatus according to a further possible arrangement not covered by the present invention where at least one of the sets of 90 degree phase shift coupling means has no resonator means provided between the same;
Figure 7a illustrates an arrangement of a set of 90 degree phase shift coupling means and resonator means according to one possible arrangement not covered by the present invention;
Figure 7b illustrates an arrangement of a set of 90 degree phase shift coupling means and resonator means according to the present invention;
Figure 8a illustrates an example of sets of 90 degree phase shift coupling means wherein the coupling means are integrated into the resonator structure according to one embodiment of the present invention in which the physical couplings are all of the same type; and
Figure 8b illustrates an example of sets of 90 degree phase shift coupling means wherein the coupling means are integrated into the resonator structure according to one embodiment of the present invention and the physical couplings are of different types.

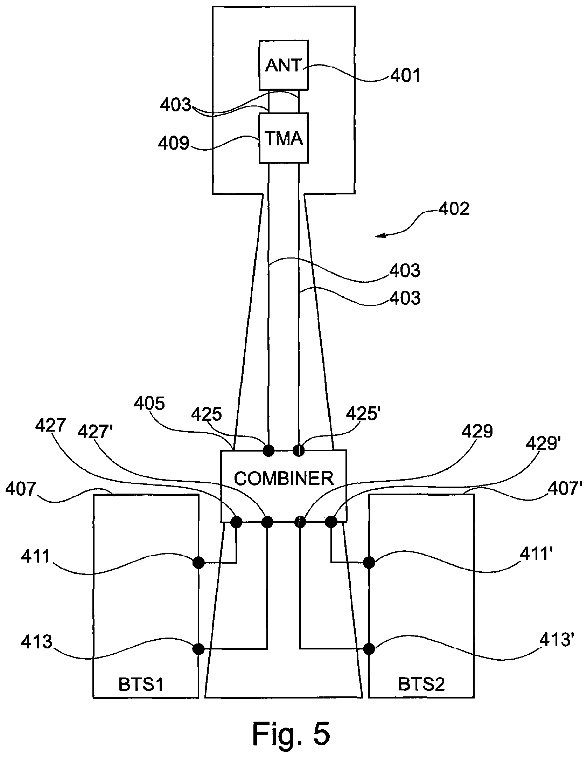

Referring firstly to Figure 5, there is illustrated an example of a cell site forming part of a wireless communication system for transmitting and/or receiving radio frequency signals. The cell site includes antenna 401, and it should be noted that this antenna can be formed from several antennas each of which covers a particular sector from the antenna mast, such as for example, three antennas spaced around the central longitudinal axis and each covering 120 degrees. For the purpose of the description, only one antenna "sector" is described and the invention herein described can, if required, be used for each of the antenna sectors. The antenna 401 in this embodiment is located at the top of a mast 402 and is connected to a tower mounted amplifier 409 via cables 403, which allows one or more radio frequency received signals to be amplified before passing via cables 403 to dual combiner apparatus 405. The dual combiner apparatus 405 is in turn connected to first and second base transceiver stations (BTSs) 407, 407'.

In the illustrated example, the BTSs 407, 407' belong to different operators who transmit and receive radio frequency signals in the same radio frequency band, such as for example 2100MHz. Thus, the first BTS 407 is operated by a first service provider or operator who transmits and receives signals at a first frequency band having two sub bands; a first sub band within a known radio frequency band for transmission and a second sub band within a known radio frequency band for receiving signals. The second base transceiver station 407' is operated by a second service provider or operator who transmits and receives signals at the same first frequency band having two frequency sub bands; a first sub band within a known radio frequency band for transmission and a second sub band within a known radio frequency band for receiving signals. It is to be noted that the first and second sub-bands of the first operator are different to the first and second sub-bands of the second operator.

The first and second BTSs 407, 407' are each provided with transmitting and receiving means 411, 411', 413, 413' for receiving and/or transmitting one or more signals from the dual combiner apparatus 405. In operation there is a need for the combining apparatus 405 to ensure that the appropriate signals are received at each of the base transceiver stations in order to allow each of the service providers to maintain their service to their customers via the common antenna. The dual combiner apparatus 405 in this embodiment includes a pair of input/output ports 427, 427' associated with the receiver and transmitter means of BTS1, and a pair of input/output ports 429, 429' associated with the receiver and transmitter means of BTS 2. In addition, dual combiner apparatus 405 has input port 425 and 425' associated with the combined signals from BTS1 and BTS2. Input/output ports 425, 425' are connected to TMA 409 via the cables 403.

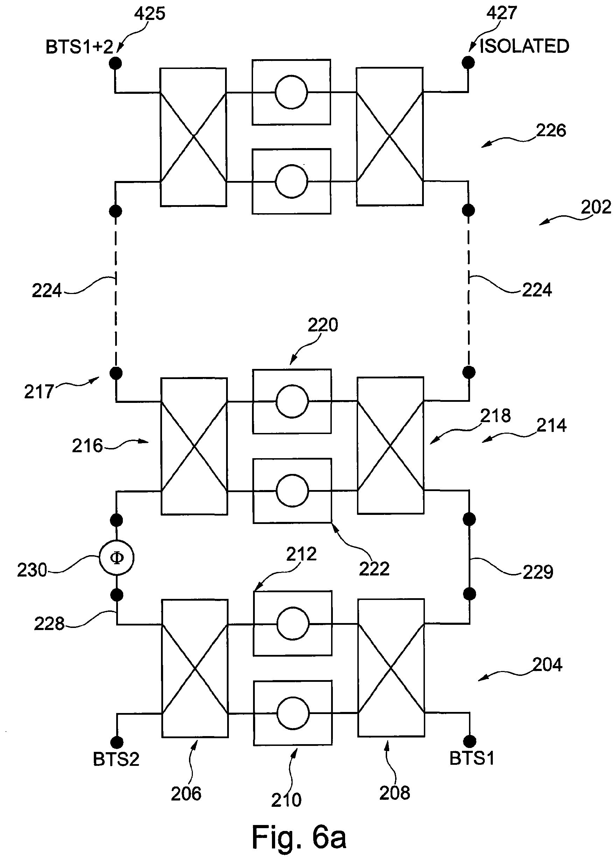

The dual combiner apparatus 405 typically has two copies of an electronic circuit associated with BTS1 and BTS2. An example of one of the electronic circuits 202 of the combiner apparatus 405 according to one possible arrangement not covered by the present invention is shown in figure 6a.

The circuit 202 includes a first set 204 of first and second 90 degree phase shift coupling means in the form of 3dB hybrid couplers 206, 208. Each coupler 206, 208 is connected to a pair of resonating means in the form of a first resonator 210 and a second resonator 212.

The circuit 202 also includes at least a second set 214 of first and second 90 degree phase shift coupling means in the form of 3dB hybrid couplers 216, 218. Each coupler 216, 218 is connected to a pair of resonating means in the form of a first resonator 220 and a second resonator 222. This arrangement allows transmission zeros to be created in the filter transfer function of the combiner apparatus without a requirement of cross coupling to be provided between resonators. As such, smaller sized combiner apparatus can be provided of reduced cost compared to prior art arrangements. In addition, as there is no direct coupling between pairs of resonators, different types or different Q technology resonators can be used within the same combiner apparatus which is not easily possible with prior art combiner apparatus arrangements.

It will be appreciated that any further number of sets of first and second 90 degree phase shift coupling means and resonators can be provided in circuit 202, as represented by dotted lines 224 and further set example 226.

Although only a single pair of resonators is shown in sets 204, 214, 226 for clarity purposes, it will be appreciated that any number of resonator pairs can be provided in each set between the 3dB hybrid couplers as required.

It is to be noted that in one embodiment you could have multiple pairs of resonators within a set of 90 degree phase shift coupling means of the apparatus. This would means that cross coupling would need to be included between the resonators to create some of the transmission zeros and it also means that the same resonator technology would need to be used within the set. However, it would allow apparatus to be produced that included two different types of resonator technologies (i.e. having high and low Q values) in different sets of 90 degree phase shift coupling means of the apparatus. All the resonators of a particular type would need to be grouped together within the same set.

The transmission path 228 provided between one side of first set 204 and second set 214 has a 180 degree phase shift 230 that means there is a 180 degree phase difference between path 230 and path 229. This allows the two or more sets of resonators 210, 212, 220, 222 to be cascaded together to produce a desired transfer function. 180 degree phase differences will typically need to be provided between the paths that connect adjacent sets in the circuit as required.

In use for example, if it is assumed that the resonators of set 204 of circuit 202 are tuned to a first sub band frequency of the transmission band of BTS 1 and the resonators of set 214 are tuned to a second sub band frequency of the transmission band of BTS 1, a radio frequency transmission signal travelling from BTS 1 that is within the first sub-band, through electronic circuit 202 of the combiner 405 to antenna 401, will reach 3dB hybrid coupler 208 of first set 204 and be split in half, with half of the signal passing through resonator 210 and half of the signal passing through resonator 212. The signal halves pass through 3 dB hybrid coupler 206 and are recombined in transmission path 228. This signal undergoes a 180 phase shift as it travels through path 230. When the signal reaches the 3dB hybrid coupler 216 of the second set of 90 degree phase shift means 214 it is then split in half, with half the signal being reflected from resonator 220 and half the signal being reflected from resonator 222. Resonators 220, 222 reflect the signal as they are resonant in the second sub band rather than the first sub band. Due to the phase characteristics of the 3dB hybrid coupler 216, the signal halves recombine at point 217. Subsequent sets, including set 226, are also not resonant in the first sub band and therefore the signals split, reflect and recombine in a similar manner and the signal arrives at port 425. A radio frequency signal that is transmitted from BTS1 and falls within the second sub-band is reflected by set 204 and passes along path 229 to set 214 that passes through to point 217. All other sets reflect the signal as it passes to port 425.

The resonator sets are tuned such that the sub bands associated with them add up to the transmission band of the BTS1. None of the sets resonate within the transmission band of BTS2 and therefore a signal transmitted from BTS2 will be reflected by all sets and pass to port 425. Therefore, port 425 will pass transmission signals from both BTS1 and BTS2. The combiner apparatus can operate in both the transmission and receive bands if the sum of the sub-bands of the sets cover both the receive and transmit bands of BTS1.

The recombined transmission signals of BTS1 and BTS2 are combined together and leave the combiner apparatus at port 425.

It is to be noted that port 427 is isolated in the illustrated example. Preferably, the port could be internally terminated, such as for example using a 50ohm load.

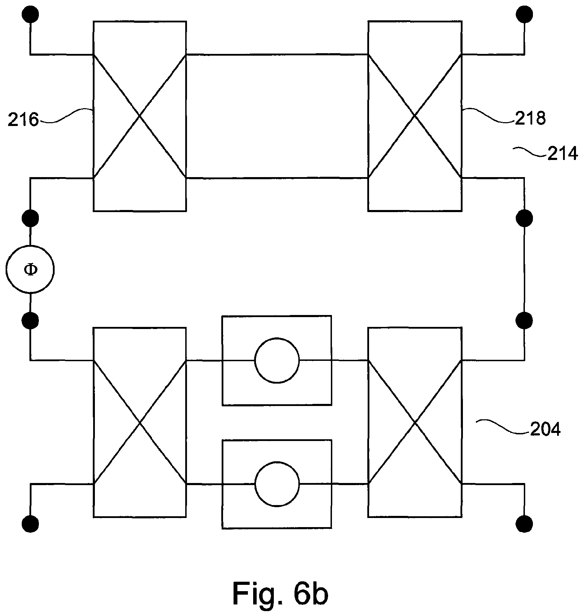

A further example of an electronic circuit for use in a combiner apparatus is shown in figure 6b. In this example, set 204 is as previously described but set 214 does not have any resonator pairs and so 3dB hybrid coupler 216 is coupled directly to 3dB hybrid coupler 218. This arrangement allows an additional transmission zero to be formed in the combiners response. It is possible to replace hybrid couplers 216 and 218 with a directional coupler whose coupling value can be varied to product a transmission zero at a desired frequency.

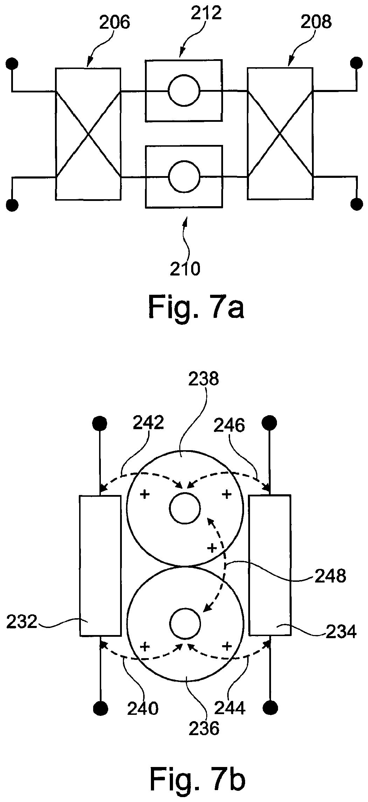

Referring to figures 7a and 7b, there is illustrated two different examples of 90 degree phase shift coupling arrangements that could be used in each set of the electronic circuit, the arrangement in figure 7b illustrates an example according to the present invention. The 90 degree phase shift coupling arrangement in figure 7a is of a type shown in figure 6a, wherein two distinct 3dB hybrid couplers are provided with at least one pair of resonators 210, 212 arranged therebetween.

The 90 degree phase shift coupling arrangement in figure 7b is integrated into the resonator structure itself using physical couplings and quarter wavelength transmission lines (i.e. transmission lines which have an electrical length of 90 degrees). More particularly, the two ends of two quarter wavelength transmission lines 232, 234 are each coupled to resonators 236, 238 as shown by arrows 240, 242, 244, 246 respectively. Resonators 236, 238 are also coupled to each other, as shown by arrow 248. This coupling arrangement has the advantage of being more compact than the arrangement using 3dB hybrid couplers. In addition, this coupling arrangement typically removes the requirement for a 180 phase shift to be provided between two or more adjacent sets of coupling arrangements in the circuit if the physical couplings are of the appropriate type.

It is to be noted that an embodiment of the apparatus can be provided wherein you can have a combination of the couplers shown in figure 7a and 7b within one electronic circuit of combiner apparatus.

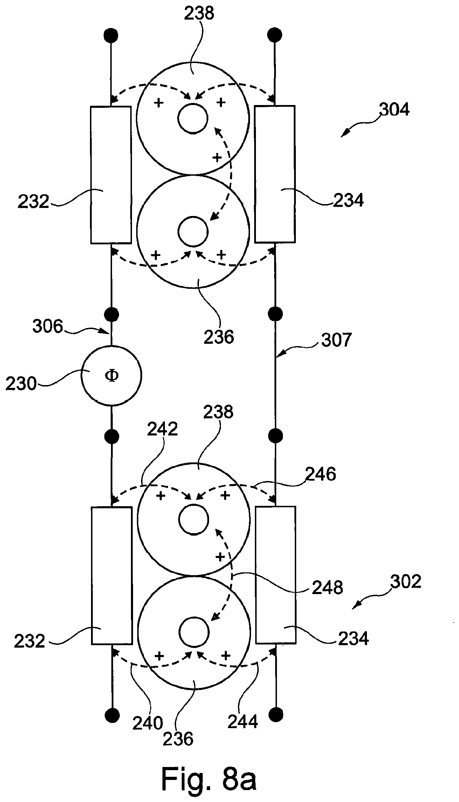

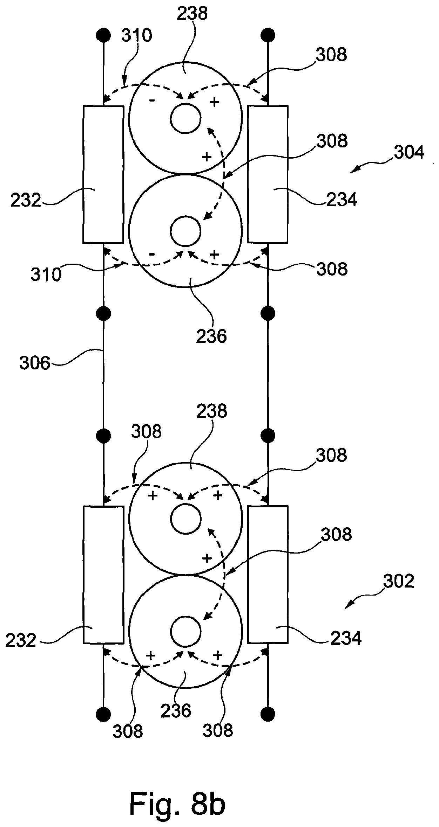

Figure 8a illustrates how two or more sets 302, 304 of 90 degree phase shift coupling arrangements of the type shown in figure 7b can be cascaded together. If the physical couplings provided between the quarter wavelength transmission lines 232, 234 and the resonators 236, 238 are all of the same type (i.e. all magnetic couplings (+ve)), a 180 degree phase shift 230 is still typically required in one of the paths 306 relative to the other path 307, between sets 302, 304 to allow cascading of the resonator pairs together. However, if some of the physical couplings provided between the quarter wavelength transmission lines 232, 234 and the resonators 236, 238 are of different types; some are magnetic (+ve) 308 and some are electrical (-ve) 310, the 180 degree relative phase shift 230 can be removed as shown in Figure 8b.

## Claims

1. Apparatus for allowing radio frequency selectivity for use in a wireless communication system for the passage of one or more receiving and/or transmission frequency signals therethrough, said apparatus including at least a first set (302) of first and second 90 degree phase shift coupling means, and at least one pair of resonating means (236, 238) coupled between the at least first and second 90 degree phase shift coupling means, wherein at least one further set (304) of first and second 90 degree phase shift coupling means are cascaded, either directly or indirectly, with said at least first set of first and second 90 degree phase shift coupling means, with or without at least one pair of resonating means (236, 238) located between the first and second 90 degree phase shift coupling means of the at least one further set (304), **characterised in that** the 90 degree phase shift coupling means is in the form of a transmission line with an electrical length of 90 degrees, or a quarter wavelength transmission line (232, 234), such that said quarter wavelength transmission line (232, 234) is provided at either side of the at least one pair of resonating means (236, 238), with each quarter wavelength transmission line (232, 234) having one end coupled to one of the resonating means (236, 238) of the pair of resonating means and the other end of the quarter wavelength transmission line (232, 234) coupled to the other resonating means (236, 238) of the pair of resonating means, and coupling is provided between the pair of resonating means (236, 238).

2. Apparatus according to claim 1 wherein the apparatus is in the form of a combiner, a multiplexer or a filter.

3. Apparatus according to claim 1 wherein the cascading between the different sets (302, 304) of first and second 90 degree phase shift coupling means is undertaken using one or more transmission lines such that one or more radio frequency signals can pass between the different sets (302, 304) of first and second 90 degree phase shift coupling means in use.

4. Apparatus according to claim 1 wherein the at least one pair of resonating means (236, 238) includes a single resonator with at least two resonator modes or sections provided in or associated with the same coupled together, and/or the at least one pair of resonating means (236, 238) includes at least two separate resonators coupled together.

5. Apparatus according to claim 1 wherein the resonating means (236, 238) used in the apparatus are of the same form, are provided with the same or similar Q value and/or are formed from the same material or wherein two or more of the resonating means (236, 238) used in the apparatus are different in form, are provided with different Q values and/or are formed from different materials.

6. Apparatus according to claim 1 wherein each of the paths separating two or more sets of 90 degree phase shift coupling means in the apparatus has a phase shift (230) and the difference between the shifts is 180 degrees.

7. Apparatus according to claim 1 wherein the first and at least second set (302, 304) of 90 degree phase shift coupling means are cascaded by connecting or coupling, either directly or indirectly, the end of the transmission line within the first 90 degree phase shift coupling means of the first set (302) of 90 degree phase shift coupling means with the start of the transmission line of the first 90 degree phase shift coupling means of the second set (304), and the end of the transmission line within the second 90 degree phase shift coupling means of the first set (302) of 90 degree phase shift coupling means with the start of the transmission line of the second 90 degree phase shift coupling means of the second set (304).

8. Apparatus according to claim 1 wherein the physical couplings between the transmission lines and the resonator means (236, 238) of a set or between sets (302, 304) can be of the same coupling type, or the physical couplings between the transmission lines and resonator means (236, 238) of one or more sets or between one or more sets (302, 304) can be of a different coupling type.

9. Apparatus according to claim 1 wherein the physical couplings between the transmission lines and the resonator means (236, 238) is symmetrical in that they have the same coupling value or wherein the physical couplings between the transmission lines and the resonator means (236, 238) is non-symmetrical or different.

10. Apparatus according to claim 1 wherein the apparatus is a combiner apparatus and the combiner apparatus communicates with at least first and second base transceiver stations.

11. Apparatus according to claim 1 wherein the resonator means (236, 238) of different sets (302, 304) of 90 degree phase shift coupling means are tuned to different frequencies.

12. Apparatus according to claim 1 wherein the resonator means (236, 238) include one or more bandpass resonators and/or one or more bandstop resonators.

13. Apparatus according to claim 1 wherein the apparatus is a dual combiner apparatus including two electronic circuits provided therein, the two electronic circuits being mirror images of each other.

14. Apparatus according to claim 1 wherein the physical couplings between the transmission lines and the resonator means of one or more of the sets or between one or more of the sets of the first and second 90 degree phase shifting coupling means are of a different coupling type and are arranged such that a 180 degree phase shift is not required in a path between the sets.

15. A method of using apparatus for allowing radio frequency selectivity for use in a wireless communication system for the passage of one or more receiving and/or transmission frequency signals therethrough, said apparatus including at least a first set (302) of first and second 90 degree phase shift coupling means, and at least one pair of resonating means (236, 238) coupled between the at least first and second 90 degree phase shift coupling means, wherein said method includes the step of cascading at least one further set (304) of first and second 90 degree phase shift coupling means, either directly or indirectly, with said at least first set of first and second 90 degree phase shift coupling means, with or without at least one pair of resonating means (236, 238) located between the first and second 90 degree phase shift coupling means of the at least one further set (304), **characterised in that** the 90 degree phase shift coupling means is in the form of a transmission line with an electrical length of 90 degrees, or a quarter wavelength transmission line (232, 234), such that said quarter wavelength transmission line (232, 234) is provided at either side of the at least one pair of resonating means (236, 238), with each quarter wavelength transmission line (232, 234) having one end coupled to one of the resonating means (236, 238) of the pair of resonating means and the other end of the quarter wavelength transmission line (232, 234) coupled to the other resonating means (236, 238) of the pair of resonating means, and coupling is provided between the pair of resonating means (236, 238)

## Patentansprüche

1. Vorrichtung zur Ermöglichung von Hochfrequenz-Selektivität zur Verwendung in einem drahtlosen Kommunikationssystem für den Durchgang von ein oder mehr Empfangs- und/oder Sendefrequenzsignalen durch es, wobei die genannte Vorrichtung mindestens einen ersten Satz (302) von ersten und zweiten 90-Grad-Phasenverschiebungs-Kopplungsmitteln und mindestens ein Paar Resonanzmittel (236, 238), die zwischen die mindestens ersten und zweiten 90-Grad-Phasenverschiebungs-Kopplungsmittel gekoppelt sind, beinhaltet, wobei mindestens ein weiterer Satz (304) von ersten und zweiten 90-Grad-Phasenverschiebungs-Kopplungsmitteln, entweder direkt oder indirekt, mit dem genannten mindestens ersten Satz von ersten und zweiten 90-Grad-Phasenverschiebungs-Kopplungsmitteln mit dem oder ohne das genannte(n) mindestens eine(n) Paar Resonanzmittel (236, 238), das sich zwischen den ersten und zweiten 90-Grad-Phasenverschiebungs-Kopplungsmitteln des mindestens einen weiteren Satzes (304) befindet, kaskadiert ist, **dadurch gekennzeichnet, dass** das 90-Grad-Phasenverschiebungs-Kopplungsmittel die Form einer Übertragungsleitung mit einer elektrischen Länge von 90 Grad oder einer Viertel-Wellenlängen-Übertragungsleitung (232, 234) hat, so dass die genannte Viertel-Wellenlängen-Übertragungsleitung (232, 234) auf beiden Seiten des mindestens einen Paars Resonanzmittel (236, 238) bereitgestellt ist, wobei jede Viertel-Wellenlängen-Übertragungsleitung (232, 234) mit einem Ende mit einem der Resonanzmittel (236, 238) des Paars Resonanzmittel gekoppelt ist und mit dem anderen Ende der Viertel-Wellenlängen-Übertragungsleitung (232, 234) mit dem anderen Resonanzmittel (236, 238) des Paars Resonanzmittel gekoppelt ist und zwischen dem Paar Resonanzmittel (236, 238) Kopplung bereitgestellt wird.

2. Vorrichtung nach Anspruch 1, wobei die Vorrichtung die Form eines Combiners, eines Multiplexers oder eines Filters hat.

3. Vorrichtung nach Anspruch 1, wobei die Kaskadierung zwischen den verschiedenen Sätzen (302, 304) von ersten und zweiten 90-Grad-Phasenverschiebungs-Kopplungsmitteln unter Verwendung von ein oder mehr Übertragungsleitungen erfolgt, so dass im Gebrauch ein oder mehr Hochfrequenzsignale zwischen den verschiedenen Sätzen (302, 304) von ersten und zweiten 90-Grad-Phasenverschiebungs-Kopplungsmitteln hindurchlaufen können.

4. Vorrichtung nach Anspruch 1, wobei das mindestens eine Paar Resonanzmittel (236, 238) einen einzelnen Resonator mit mindestens zwei miteinander gekoppelten Resonatormoden oder -abschnitten, die in demselben bereitgestellt oder ihm zugeordnet sind, beinhaltet und/oder das mindestens eine Paar Resonanzmittel (236, 238) mindestens zwei separate, miteinander gekoppelte Resonatoren beinhaltet.

5. Vorrichtung nach Anspruch 1, wobei die in der Vorrichtung verwendeten Resonanzmittel (236, 238) die gleiche Form haben, mit demselben oder einem ähnlichen Q-Wert versehen sind und/oder aus dem gleichen Material hergestellt sind oder wobei zwei oder mehr der in der Vorrichtung verwendeten Resonanzmittel (236, 238) sich in der Form unterscheiden, mit verschiedenen Q-Werten versehen sind und/oder aus verschiedenen Materialien hergestellt sind.

6. Vorrichtung nach Anspruch 1 wobei jeder der die zwei oder mehr Sätze von 90-Grad-Phasenverschiebungs-Kopplungsmitteln in der Vorrichtung trennenden Wege eine Phasenverschiebung (230) aufweisen und der Unterschied zwischen den Verschiebungen 180 Grad ist.

7. Vorrichtung nach Anspruch 1 wobei der erste und der mindestens zweite Satz (302, 304) von 90-Grad-Phasenverschiebungs-Kopplungsmitteln durch Verbinden oder Koppeln, entweder direkt oder indirekt, des Endes der Übertragungsleitung innerhalb des ersten 90-Grad-Phasenverschiebungs-Kopplungsmittels des ersten Satzes (302) von 90-Grad-Phasenverschiebungs-Kopplungsmitteln mit dem Anfang der Übertragungsleitung des ersten 90-Grad-Phasenverschiebungs-Kopplungsmittels des zweiten Satzes (304) und des Endes der Übertragungsleitung innerhalb des zweiten 90-Grad-Phasenverschiebungs-Kopplungsmittels des ersten Satzes (302) von 90-Grad-Phasenverschiebungs-Kopplungsmitteln mit dem Anfang der Übertragungsleitung des zweiten 90-Grad-Phasenverschiebungs-Kopplungsmittels des zweiten Satzes (304) kaskadiert sind.

8. Vorrichtung nach Anspruch 1, wobei die physischen Kopplungen zwischen den Übertragungsleitungen und den Resonatormitteln (236, 238) eines Satzes oder zwischen Sätzen (302, 304) vom gleichen Kopplungstyp sein können oder die physischen Kopplungen zwischen den Übertragungsleitungen und Resonatormitteln (236, 238) von ein oder mehr Sätzen oder zwischen ein oder mehr Sätzen (302, 304) von einem verschiedenen Kopplungstyp sein können.

9. Vorrichtung nach Anspruch 1, wobei die physischen Kopplungen zwischen den Übertragungsleitungen und den Resonatormitteln (236, 238) insofern symmetrisch sind, als sie den gleichen Kopplungswert aufweisen, oder wobei die physischen Kopplungen zwischen den Übertragungsleitungen und den Resonatormitteln (236, 238) nichtsymmetrisch oder verschieden sind.

10. Vorrichtung nach Anspruch 1, wobei die Vorrichtung eine Combiner-Vorrichtung ist und die Combiner-Vorrichtung mit mindestens einer ersten und einer zweiten Basissendeempfängerstationen kommuniziert.

11. Vorrichtung nach Anspruch 1, wobei die Resonatormittel (236, 238) von verschiedenen Sätzen (302, 304) von 90-Grad-Phasenverschiebungs-Kopplungsmitteln auf verschiedene Frequenzen abgestimmt sind.

12. Vorrichtung nach Anspruch 1, wobei die Resonatormittel (236, 238) ein oder mehr Bandpass-Resonatoren und/oder ein oder mehr Bandsperren-Resonatoren beinhalten.

13. Vorrichtung nach Anspruch 1, wobei die Vorrichtung eine Doppel-Combiner-Vorrichtung ist, die zwei darin bereitgestellte elektronische Schaltungen beinhaltet, wobei die zwei elektronischen Schaltungen Spiegelbilder voneinander sind.

14. Vorrichtung nach Anspruch 1, wobei die physischen Kopplungen zwischen den Übertragungsleitungen und den Resonatormitteln von ein oder mehr der Sätze oder zwischen ein oder mehr der Sätze der ersten und zweiten 90-Grad-Phasenverschiebung-Kopplungsmittel von einem verschiedenen Kopplungstyp sind und so angeordnet sind, dass eine Phasenverschiebung von 180 Grad in einem Weg zwischen den Sätzen nicht erforderlich ist.

15. Verfahren zur Verwendung einer Vorrichtung zur Ermöglichung von Hochfrequenz-Selektivität zur Verwendung in einem drahtlosen Kommunikationssystem für den Durchgang von ein oder mehr Empfangs- und/oder Sendefrequenzsignalen durch es, wobei die genannte Vorrichtung mindestens einen ersten Satz (302) von ersten und zweiten 90-Grad-Phasenverschiebungs-Kopplungsmitteln und mindestens ein Paar Resonanzmittel (236, 238), die zwischen die mindestens ersten und zweiten 90-Grad-Phasenverschiebungs-Kopplungsmittel gekoppelt sind, beinhaltet, wobei das genannte Verfahren den Schritt des Kaskadierens von mindestens einem weiteren Satz (304) von ersten und zweiten 90-Grad-Phasenverschiebungs-Kopplungsmitteln, entweder direkt oder indirekt, mit dem genannten mindestens ersten Satz von ersten und zweiten 90-Grad-Phasenverschiebungs-Kopplungsmitteln mit oder ohne mindestens ein(em) Paar Resonanzmittel (236, 238), das sich zwischen den ersten und zweiten 90-Grad-Phasenverschiebungs-Kopplungsmitteln des mindestens einen weiteren Satzes (304) befindet, beinhaltet, **dadurch gekennzeichnet, dass** das 90-Grad-Phasenverschiebungs-Kopplungsmittel die Form einer Übertragungsleitung mit einer elektrischen Länge von 90 Grad oder einer Viertel-Wellenlängen-Übertragungsleitung (232, 234) hat, so dass die genannte Viertel-Wellenlängen-Übertragungsleitung (232, 234) auf beiden Seiten des mindestens einen Paars Resonanzmittel (236, 238) bereitgestellt ist, wobei jede Viertel-Wellenlängen-Übertragungsleitung (232, 234) mit einem Ende mit einem der Resonanzmittel (236, 238) des Paars Resonanzmittel gekoppelt ist und mit dem anderen Ende der Viertel-Wellenlängen-Übertragungsleitung (232, 234) mit dem anderen Resonanzmittel (236, 238) des Paars Resonanzmittel gekoppelt ist und zwischen dem Paar Resonanzmittel (236, 238) Kopplung bereitgestellt wird.

## Revendications

1. Appareil pour permettre une sélectivité de radiofréquence pour une utilisation dans un système de communication sans fil pour le passage d'un ou de plusieurs signaux en fréquence de réception et/ou de transmission à travers celui-ci, ledit appareil incluant au moins un premier ensemble (302) de premier et deuxième moyens de couplage de déphasage à 90 degrés, et au moins une paire de moyens de résonance (236, 238) couplés entre les au moins premier et deuxième moyens de couplage de déphasage à 90 degrés, dans lequel au moins un ensemble supplémentaire (304) de premier et deuxième moyens de couplage de déphasage à 90 degrés sont mis en cascade, soit directement soit indirectement, avec ledit au moins premier ensemble de premier et deuxième moyens de couplage de déphasage à 90 degrés, avec ou sans au moins une paire de moyens de résonance (236, 238) localisés entre les premier et deuxième moyens de couplage de déphasage à 90 degrés de l'au moins un ensemble supplémentaire (304), **caractérisé en ce que** les moyens de couplage de déphasage à 90 degrés se présentent sous la forme d'une ligne de transmission avec une longueur électrique de 90 degrés, ou d'une ligne de transmission en quart d'onde (232, 234), de telle sorte que ladite ligne de transmission en quart d'onde (232, 234) soit prévue de chaque côté de l'au moins une paire de moyens de résonance (236, 238), alors que chaque ligne de transmission en quart d'onde (232, 234) a une extrémité couplée à un des moyens de résonance (236, 238) de la paire de moyens de résonance et l'autre extrémité de la ligne de transmission en quart d'onde (232, 234) est couplée à l'autre moyen de résonance (236, 238) de la paire de moyens de résonance, et un couplage est prévu entre la paire de moyens de résonance (236, 238).

2. Appareil selon la revendication 1, l'appareil se présentant sous la forme d'un combineur, d'un multiplexeur ou d'un filtre.

3. Appareil selon la revendication 1 dans lequel la mise en cascade entre les différents ensembles (302, 304) de premier et deuxième moyens de couplage de déphasage à 90 degrés est effectuée grâce à l'utilisation d'une ou de plusieurs lignes de transmission de telle sorte qu'un ou plusieurs signaux de radiofréquence puissent passer entre les différents ensembles (302, 304) de premier et deuxième moyens de couplage de déphasage à 90 degrés en utilisation.

4. Appareil selon la revendication 1 dans lequel l'au moins une paire de moyens de résonance (236, 238) inclut un résonateur individuel ayant au moins deux sections ou modes de résonateur prévus dans ou associés à ceux-ci qui sont couplés ensemble, et/ou l'au moins une paire de moyens de résonance (236, 238) inclut au moins deux résonateurs séparés qui sont couplés ensemble.

5. Appareil selon la revendication 1 dans lequel les moyens de résonance (236, 238) utilisés dans l'appareil ont la même forme, sont dotés d'une valeur Q identique ou similaire et/ou sont formés à partir du même matériau ou dans lequel deux ou plusieurs des moyens de résonance (236, 238) utilisés dans l'appareil ont une forme différente, sont dotés de différentes valeurs Q et/ou sont formés à partir de matériaux différents.

6. Appareil selon la revendication 1 dans lequel chacun des trajets séparant deux ou plusieurs ensembles de moyens de couplage de déphasage à 90 degrés dans l'appareil présente un déphasage (230) et la différence entre les déphasages est de 180 degrés.

7. Appareil selon la revendication 1 dans lequel les premier et au moins deuxième ensembles (302, 304) de moyens de couplage de déphasage à 90 degrés sont mis en cascade grâce à la connexion ou au couplage, soit directement soit indirectement, de l'extrémité de la ligne de transmission au sein du premier moyen de couplage de déphasage à 90 degrés du premier ensemble (302) de moyens de couplage de déphasage à 90 degrés avec le début de la ligne de transmission du premier moyen de couplage de déphasage à 90 degrés du deuxième ensemble (304), et l'extrémité de la ligne de transmission au sein du deuxième moyen de couplage de déphasage à 90 degrés du premier ensemble (302) de moyens de couplage de déphasage à 90 degrés avec le début de la ligne de transmission du deuxième moyen de couplage de déphasage à 90 degrés du deuxième ensemble (304).

8. Appareil selon la revendication 1 dans lequel les couplages physiques entre les lignes de transmission et les moyens résonateurs (236, 238) d'un ensemble ou entre des ensembles (302, 304) peuvent être du même type de couplage, ou les couplages physiques entre les lignes de transmission et les moyens résonateurs (236, 238) d'un ou de plusieurs ensembles ou entre un ou plusieurs ensembles (302, 304) peuvent être d'un type de couplage différent.

9. Appareil selon la revendication 1 dans lequel les couplages physiques entre les lignes de transmission et les moyens résonateurs (236, 238) sont symétriques en ce qu'ils ont la même valeur de couplage ou dans lequel les couplages physiques entre les lignes de transmission et les moyens résonateurs (236, 238) sont non symétriques ou différents.

10. Appareil selon la revendication 1, l'appareil étant un appareil combineur et l'appareil combineur communiquant avec au moins des première et deuxième stations émettrices-réceptrices de base.

11. Appareil selon la revendication 1 dans lequel les moyens résonateurs (236, 238) de différents ensembles (302, 304) de moyens de couplage de déphasage à 90 degrés sont accordés à des fréquences différentes.

12. Appareil selon la revendication 1 dans lequel les moyens résonateurs (236, 238) incluent un ou plusieurs résonateurs passe-bande et/ou un ou plusieurs résonateurs coupe-bande.

13. Appareil selon la revendication 1, l'appareil étant un appareil combineur double incluant deux circuits électroniques qui sont prévus dans celui-ci, les deux circuits électroniques étant des images miroirs l'un de l'autre.

14. Appareil selon la revendication 1 dans lequel les couplages physiques entre les lignes de transmission et les moyens résonateurs d'un ou de plusieurs des ensembles ou entre un ou plusieurs des ensembles des premier et deuxième moyens de couplage de déphasage à 90 degrés sont d'un type de couplage différent et sont agencés de telle sorte qu'un déphasage à 180 degrés ne soit pas requis dans un trajet entre les ensembles.

15. Procédé d'utilisation d'un appareil pour permettre une sélectivité de radiofréquence pour une utilisation dans un système de communication sans fil pour le passage d'un ou de plusieurs signaux en fréquence de réception et/ou de transmission à travers celui-ci, ledit appareil incluant au moins un premier ensemble (302) de premier et deuxième moyens de couplage de déphasage à 90 degrés, et au moins une paire de moyens de résonance (236, 238) couplés entre les au moins premier et deuxième moyens de couplage de déphasage à 90 degrés, dans lequel ledit procédé inclut l'étape de mise en cascade d'au moins un ensemble supplémentaire (304) de premier et deuxième moyens de couplage de déphasage à 90 degrés, soit directement soit indirectement, avec ledit au moins premier ensemble de premier et deuxième moyens de couplage de déphasage à 90 degrés, avec ou sans au moins une paire de moyens de résonance (236, 238) localisés entre les premier et deuxième moyens de couplage de déphasage à 90 degrés de l'au moins un ensemble supplémentaire (304), **caractérisé en ce que** les moyens de couplage de déphasage à 90 degrés se présentent sous la forme d'une ligne de transmission avec une longueur électrique de 90 degrés, ou d'une ligne de transmission en quart d'onde (232, 234), de telle sorte que ladite ligne de transmission en quart d'onde (232, 234) soit prévue de chaque côté de l'au moins une paire de moyens de résonance (236, 238), alors que chaque ligne de transmission en quart d'onde (232, 234) a une extrémité couplée à un des moyens de résonance (236, 238) de la paire de moyens de résonance et l'autre extrémité de la ligne de transmission en quart d'onde (232, 234) est couplée à l'autre moyen de résonance (236, 238) de la paire de moyens de résonance, et un couplage est prévu entre la paire de moyens de résonance (236, 238).
